Europäisches Patentamt

European Patent Office

Office européen des brevets

(19)

(11) Publication number: **0 341 843**
**A2**

# EUROPEAN PATENT APPLICATION

(21) Application number: **89303819.0**

(22) Date of filing: **18.04.89**

(51) Int. Cl.⁴: **G03F 7/02**

(30) Priority: **09.05.88 US 191666**

(43) Date of publication of application:
**15.11.89 Bulletin 89/46**

(84) Designated Contracting States:
**DE FR GB**

(71) Applicant: **International Business Machines Corporation**
**Old Orchard Road**
**Armonk, N.Y. 10504(US)**

(72) Inventor: **Ito, Hiroshi**
**7149 Echo Ridge Drive**
**San Jose, CA 95120(US)**
Inventor: **Krounbi, Mohamad Towfik**
**6238 Paso Los Cerritos**
**San Jose, CA 95120(US)**
Inventor: **Lee, Rodney Edgar**
**17845 Northwood Place**
**Salinas, CA 93907(US)**

(74) Representative: **Hobbs, Francis John**
**IBM United Kingdom Limited Intellectual**
**Property Department Hursley Park**
**Winchester Hampshire SO21 2JN(GB)**

(54) **A process of forming a conductor pattern.**

(57) A conductor pattern is formed by a metal lift-off process comprising the steps of coating a substrate (1) with a layer (2) of low molecular weight poly(methyl glutarimide); overcoating the poly(methyl glutarimide) (3) with a layer of photoresist; exposing the photoresist to radiation through a mask; developing both the photoresist and the poly(methyl glutarimide); depositing a conductor (4); and lifting off the remaining portion of the poly(methyl glutarimide) by means of a solvent. The process is adaptable to provide a beveled lead track for magnetic recordings.

FIG. 3

EP 0 341 843 A2

# A PROCESS OF FORMING A CONDUCTOR PATTERN

This invention relates to a process of forming a conductor pattern on a substrate by a metal lift-off technique.

U.S. -A- 3,964,908 discloses the use of resists containing dimethylglutarimide units. U.S. -A- 4,524,121 refers to positive photoresists containing preformed polyglutarimide. U.S. -A- 4,568,411 describes a process for metal/semiconductor deposition using a two-layer photoresist mask. U.S. -A- 4,569,897 describes a negative photoresist composition with polyglutarimide. For the purposes of that invention, the polyglutarimide has a molecular weight from 2,000 to about 500,000. U.S. -A- 4,606,998 describes a barrierless high-temperature lift-off process using two layers of polyimide.

It should be noted that none of the above cited prior art shows the sequence of steps required by the process of the present invention. In particular, none of the prior art shows a process, in which the PMGI is not exposed to radiation.

Metal lift-off has traditionally been achieved through producing undercut profiles in resist films. Undercut profiles are typically generated with use of a negative resist opaque at the exposing wavelength, image reversal of a positive photoresist, or with the use of bilayer or trilayer schemes consisting of a thin cap and a thick bottom layer. These systems are useful when metals are deposited by evaporation. However, sputter deposition results in a serious fencing problem, i.e. side walls of the undercut structures are coated with metallic films, which make the lift-off very difficult and the metal edge definition very poor. The multilayer systems mentioned above are quite complex and involve many coating steps and multiple exposures or the use of etching tools. Furthermore, they do not avoid the fencing of sputter-deposited metals.

The present invention seeks to provide a simple process for metal lift-off that is devoid of fencing and achieves clean lifting without difficulty.

The invention provides a process of forming a conductor pattern on a substrate comprising the successive steps of (a) coating the substrate with a layer of low molecular weight poly(methyl glutarimide); (b) overcoating the poly(methyl glutarimide) layer with a layer of photoresist; (c) exposing the photoresist to radiation through a mask; (d) developing both the photoresist and the poly(methyl glutarimide); (e) depositing a conductor; and (f) lifting off the remaining portion of the poly(methyl glutarimide) by means of a solvent.

For use in the present invention, the PMGI should preferably have a weight average molecular weight (polystyrene as a standard) within the range of 3,000 to 40,000. The choice of the molecular weight depends on the depth of undercut desired for specific applications, which is also a function of bake temperature and time as well as of developer strength and development time. Thus, it is possible to produce desired undercut by varying the above-mentioned parameters. An absolute weight average molecular weight of approximately 30,000 (19,000 as determined by GPC with polystyrene as a standard) is most preferred in the examples given below. Such low molecular weight material is commercially available from the Shipley Company. Alternatively, high molecular weight PMGI could be used if blanket deep UV exposure is performed to lower the molecular weight to the desired range prior to coating the photoresist.

How the invention can be carried out will now be described by way of example, with reference to the accompanying drawings, in which:-

Figs. 1 - 4 illustrate cross-sections, not to scale, of the structures formed during the steps of a process embodying the invention.

Fig. 1 shows a substrate (1) coated with a layer of PMGI (2) and then with a photoresist (3). The resist is exposed to radiation through a mask. Both the resist and the PMGI are then developed, leaving the structure as shown in Fig. 2, with the PMGI undercut below the resist. Conductor metal is next deposited, e. g. by sputtering, leading to the formation of a covering (4) for the substrate and for the resists as shown in Fig. 3. Finally, lift-off is carried out using, for example, an organic solvent or aqueous alkali. The result is shown in Fig. 4, wherein the substrate has been selectively coated with a conductor without any fencing problems.

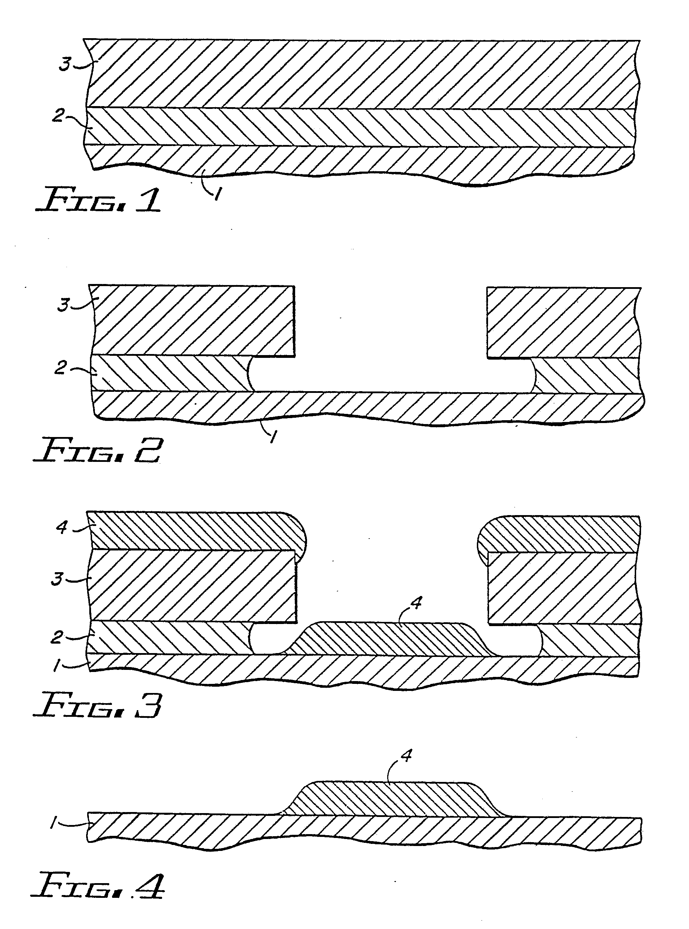

The top imaging resist includes aqueous base developable photoresists either positive or negative working. Such examples are diazonaphthoquinone/novolac positive photoresists, the dual tone resist systems described in U.S. -A- 4,491,628, and the image reversal negative resists described in U.S. -A- 4,104,070.

The imaging radiation is not limited to UV light but electron beam, x-ray, or ion-beam can be employed. The process described in this specification is useful in the metal lift-off employing sputter deposition and is particularly useful when a long metal edge taper is desired for better step coverage. In addition, application of the invention provides a simple method of producing well defined metal patterns when evaporation or evaporation/sputter hybrid deposition is employed. Thus, the process described herein is useful when metals are deposited either by evaporation or by sputtering.

The thickness of the imaging layer determines the degree of taper when sputtering is employed. A thicker imaging layer results in a longer taper.

The thickness of the PMGI layer depends on the desired thickness of deposited metals. The PMGI layer should be slightly thinner than deposited metals for better metal edge definition and ready lift-off when metals are deposited by sputtering. In the case of evaporation, the PMGI layer should be thicker than the deposited metals.

In a preferred variation of the present invention, the process may be adapted to define a magnetic recording read track width. The process of the present invention leads to a beveled lead track (BLT). In the process described above, the total development time is the sum of the resist development time (t1) and the PMGI underlayer development time (t2). The undercut into the PMGI layer is a linear function of t2 time and thus, proportional to the overall development time since for a given resist system and a specific dosage, the resist endpoint time or t1 is constant. Thus, long development times (more than five minutes) generate a long undercut which is good for easy resist lift-off but bad for track definition due to a long conductor taper. A short development time (less than five minutes) generates a short undercut which is good for track definition but bad for resist lift-off. The process of the present invention can be adapted by a compromise in which a short undercut is achieved in the critical track region and a long undercut in the non-critical region in the conductor pattern. We have called the scheme the "beveled lead track" (BLT) process. The way to achieve different undercuts in a single patterning layer is by having the ability to vary the development time in different regions of the conductor pattern. In the BLT process, this is done by using two different masks to define the overall conductor pattern. The first mask defines non-critical regions of the conductor and the second mask defines the critical track region of the device. Both masks are exposed onto a single bilayer resist structure. In most resist systems the development endpoint (t1) is inversely proportional to the exposure dose. The t1 times at 400 and 150 mj/cm$^2$ are one and three minutes, respectively. When mask 1 (non-critical) is exposed at 400 mj and mask 2 (critical) is exposed at 150 mj and the total development time is five minutes, the PMGI development times (t2) will be four and two minutes, respectively. The resulting undercut in the low exposure dose will be 0.4 $\mu$m. In the high exposure area, the undercut will be 0.8 $\mu$m. The short undercut provides good track definition while the long undercut aids the resist lift-off step.

The following Examples are given solely for purposes of illustration and are not to be considered limitations of the present invention.

## Example I

The following gives the process details for carrying out the invention in a preferred fashion.

| Prebake | 5 min., 92°C |
|---|---|
| Apply Resist | PMGI, 4000 RPM, 150nm thickness, spin 30 sec. |
| Soft Bake | Hot Plate, 30 min., 185°C |
| Apply Resist | Diazoquinone photoresist, 3000 RPM, 0.7$\mu$m thickness, spin 60 sec. |
| Soft Bake | Hot Plate, 30 min., 92°C |
| Expose | 180 mJ/cm2 |
| Develop | MP-2401, 1:5, 4.0 min., 21°C±1°C |
| Spray Rinse | 5 cycles |
| Spin Dry | Semitool |
| Inspection | Scope, alignment and residual resist |

This process yielded 0.4 $\mu$m lateral undercut. With this stencil, a metal thickness of 200nm was sputter deposited.

## Example II

The following gives the process details for the beveled lead track process.

| Prebake | Hot Plate, 5 min., 92°C, |
|---|---|
| Apply Resist | PMGI, 4000 RPM, spin 30 sec. |
| Soft Bake | Hot Plate, 30 min., 185°C |
| Apply Resist | Diazoquinone photoresist, 2750 RPM, 0.7μm thickness, spin 60 sec. |
| Soft Bake | Hot Plate, 30 min., 92°C |
| Expose | Mask 1, 300 mJ/cm2 on PE center focus |
| Develop (Optional) | MP-2401, 1:5, 2.0 min., 21°C±1°C |
| Expose | Mask 2, 180 mJ/cm2 on PE center focus |
| Develop | MP-2401, 1:5, 2.5 min., 21°C±1°C |
| Spray Rinse | 5 cycles |
| Spin Dry | Semitool |
| Inspection | Scope, alignment and residual resist |

This process yielded a lateral undercut of 0.3 μm in the critical regions, and 0.5 μm in the non-critical areas.

## Claims

1. A process of forming a conductor pattern on a substrate (1) comprising the successive steps of (a) coating the substrate with a layer (2) of low molecular weight poly(methyl glutarimide); (b) overcoating the poly(methyl glutarimide) layer with a layer (3) of photoresist; (c) exposing the photoresist to radiation through a mask; (d) developing both the photoresist and the poly(methyl glutarimide); (e) depositing a conductor (4); and (f) lifting off the remaining portion of the poly(methyl glutarimide) by means of a solvent.

2. A process as claimed in claim 1, wherein the molecular weight of the poly(methyl glutarimide) is in the range of 3,000 to 40,000.

3. A process as claimed in claim 1, wherein the absolute weight average molecular weight of the poly-(methyl glutarimide) is approximately 30,000.

4. A process as claimed in any preceding claim, in which the photoresist is exposed in step (c) of the process through a first mask and then through a second mask, the first mask defining a non-critical region of the conductor, and the second mask defining a critical region of the conductor; and in which the development times of step (d) are coordinated to define the overall conductor pattern.

5. A process as claimed in claim 4 which is adapted to provide a beveled lead track for a magnetic recording.

6. A process as claimed in any preceding claim, wherein the conductor is deposited by sputtering.

3

2

_FIG. 1_

3

2

_FIG. 2_

4

3

2

1

_FIG. 3_

4

1

_FIG. 4_